# EUROPEAN PATENT SPECIFICATION

(11) **EP 1 834 321 B1**
(45) Date of publication and mention of the grant of the patent: **09.07.2014**
(21) Application number: 05854008.9
(22) Date of filing: 14.12.2005
(51) Int. Cl.: H04B 15/00, H04B 1/00

(54) **METHOD AND SYSTEM FOR REDUCING SIGNAL INTERFERENCE**
VERFAHREN UND SYSTEM ZUR REDUZIERUNG VON SIGNALSTÖRUNGEN
PROCEDE ET SYSTEME DE REDUCTION DE L'INTERFERENCE DE SIGNAUX

(30) Priority: 14.12.2004 US 635817 P; 10.06.2005 US 689467 P; 06.07.2005 US 696905 P; 21.09.2005 US 719055 P; 23.09.2005 US 720324 P
(43) Date of publication of application: 19.09.2007
(60) Divisional application: 13004341.7
(73) Proprietor: Intersil Americas LLC, Milpitas, CA 95035 (US)
(72) Inventor: GEBARA, Edward, Atlanta, GA 30309 (US); LASKAR, Joy, Marietta, GA 30068 (US); TENTZERIS, Emmanouil, M., Atlanta, GA 30319 (US); KIM, Andrew, Joo, Atlanta, GA 30363 (US); STELLIGA, Anthony, Cupertino, CA 95014 (US)
(74) Representative: Grünecker, Kinkeldey, Stockmair & Schwanhäusser
(86) International application number: PCT/US2005/045209
(87) International publication number: WO 2006/065883

(56) References cited:
- US-A- 5 574 978
- US-A1- 2004 053 578
- US-A1- 2004 114 888

## Description

This application claims the benefit of priority to U.S. Provisional Patent Application Serial No. 60/635,817, entitled "Electromagnetic Interference Wireless Canceller," filed on December 14, 2004 in the name of Gebara et al.

This application further claims the benefit of priority to U.S. Provisional Patent Application Serial No. 60/689,467, entitled "Automatic Gain and Phase Control for an Interference Cancellation Device," filed on June 10, 2005 in the name of Kim et al.

This application further claims the benefit of priority to U.S. Provisional Patent Application Serial No. 60/696,905, entitled "Control Loop for Active Noise Canceller in Wireless Communication System," filed on July 6, 2005 in the name of Schmukler et al.

This application further claims the benefit of priority to U.S. Provisional Patent Application Number 60/719,055, entitled "Method and System for Embedded Detection of Electromagnetic Interference," filed on September 21, 2005 in the name of Stelliga et al.

This application further claims the benefit of priority to U.S. Provisional Patent Application Number 60/720,324, entitled "Method and System for Reducing Power Consumption in an Interference Cancellation Device of a Wireless System," filed on September 23, 2005 in the name of Stelliga et al.

The present invention relates to the field of communications, and more specifically to improving signal fidelity in a communication system by compensating for interference that occurs between two or more communication channels.

Electro-Magnetic Interference ("EMI") is a major concern in wireless communication systems. These systems transmit and receive electro-magnetic ("EM") signals to communicate data. Examples of such systems include mobile phones, wireless data networks (e.g. networks conforming to IEEE standards 802.11a/b/g/n), and global position systems/sensors ("GPSs"). EMI can become a problem when high-speed circuitry is routed in close proximity to a radio receiver. In particular, a high-speed signal can cause the emission of EMI, and when such a signal is routed in close proximity to a radio receiver, the receiver can undesirably receive the interference along with the intended received radio signal, termed the "victim" signal. The signal that imposes the interference can be termed the "aggressor" or "aggressing" signal. Thus, EMI often degrades the signal fidelity of the victim signal and impairs the quality of the radio reception. Exemplary sources of interference sources can include, among others, a high-speed bus carrying data from a processor to a high-resolution display and a high-speed bus carrying data from a camera imaging sensor to a processor.

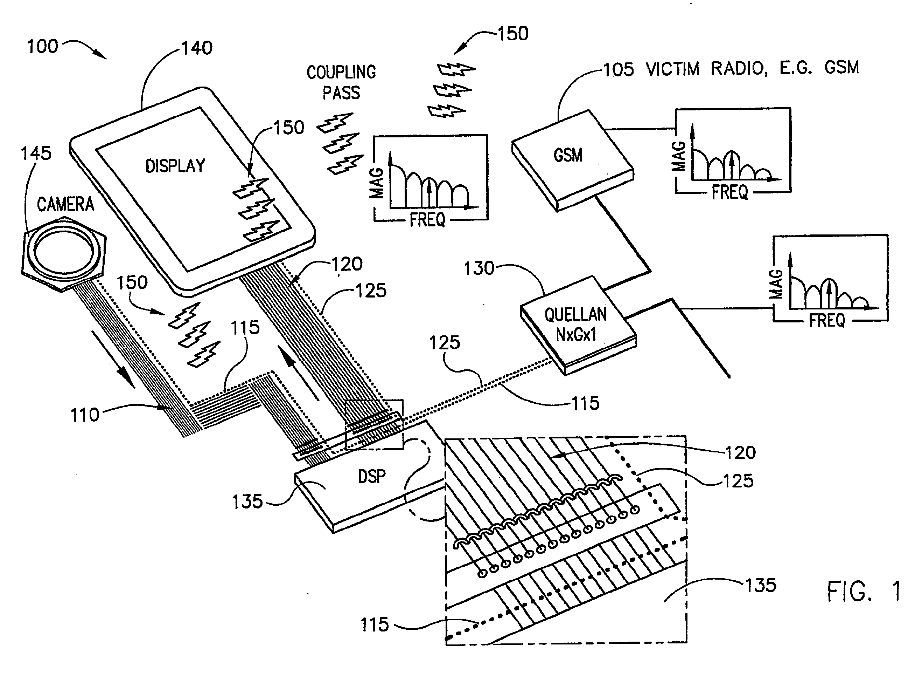

As an example, Figure 1 illustrates the interference phenomenon in a mobile phone system 100 (along with a solution discussed below, in the form of an exemplary embodiment of the present invention), where a general/global system for mobile communications ("GSM") radio receiver 105 can be aggressed by one or more interference sources. Specifically, Figure 1 illustrates two such exemplary EMI sources **110,120,** each emitting and/or receiving interference **150.** One EMI source is a high-speed bus **120** carrying data from a digital signal processing ("DSP") chip **135** to a high-resolution display **140.** The other EMI source is a high-speed bus **110** carrying data from a camera imaging sensor **145** to the DSP chip **135.** The camera imaging sensor **145** could comprise lenses coupled to a charge coupled device ("CCD"), for example.

Increasing the data rate or bandwidth of each lane, conductor, or channel of the display and camera busses **110, 120** is often desirable. This desire may be motivated by (i) a need to support higher display/camera resolution, which entails faster throughput commensurate with increasing the number of image pixels and/or (ii) a desire to reduce the number of data lanes in the bus **110, 120,** thereby involving an increase in the data rate on the remaining lanes to support the existing aggregate throughput. Thus, improvements in the display **140** or camera system **145** (e.g. higher resolution or condensed communication bus) can degrade the performance of the radio receiver **105** in the mobile phone system **100.**

Furthermore, it may be desired to improve the radio reception of mobile phones, such as cellular phones, with existing display/camera and bus technologies, i.e. to facilitate reception of weak radio signals. In other words, improving reception of low-power signals or noisy signals provides another motivation to reduce or to otherwise address interference **150** or crosstalk. A weak radio signal might have less intensity than the noise level of the EMI **150,** for example. Thus, it is desired to reduce the EMI **150** to facilitate reception of weaker radio signals or to enable operating a mobile phone or other radio in a noisy environment.

High-speed busses **110, 120** emitting, carrying, providing, imposing, and/or receiving interference can take multiple forms. For instance, in the mobile phone application described above, the bus **120** carrying the display data is often embodied as a "flex cable" which is sometimes referred to as a "flex circuit" or a "ribbon cable." A flex cable typically comprises a plurality of conductive traces or channels (typically copper conductors) embedded, laminated, or printed on in a flexible molding structure such as a plastic or polymer film or some other dielectric or insulating material.

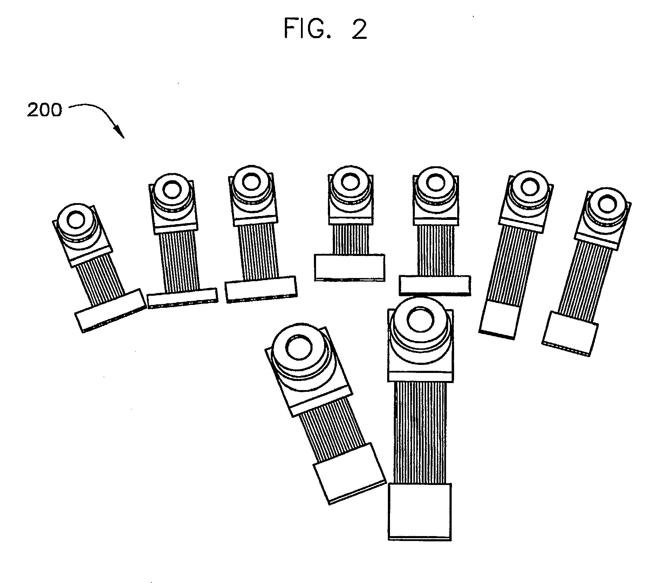

Figure 2 illustrates several flex cables **200** any of which could comprise the data busses **110, 120** inside a mobile phone or another electronic device. (As discussed in more detail below, those flex cables **200** can be adapted to comprise an exemplary embodiment of the present invention.) The high-speed buses **110, 120** may also take the form of a plurality of conductive traces routed on a rigid dielectric substrate or material, such as circuit traces printed on, deposited on, embedded in, or adhering to a circuit board ("PCB").

EMI 150 can also become problematic when two or more radio services are operated on the same handset. In this situation, the transmitted signal for a first radio service may interfere with the received signal for a second radio service. Such interference can occur even when two or more services utilize different frequency bands as a result of (i) the transmitted power of the first signal being significantly larger than the received power of the second signal and/or (ii) limited or insufficient suppression of sidebands in practical radio implementations. Consequently, a small fraction of the first, transmitted signal can leak into the second, received signal as interference.

A third source of EMI 150 can be circuits or circuit elements located in close proximity to a victim channel or radio. Like the signals on the high-speed buses **110, 120,** signals flowing through a circuit or circuit component can emit EMI **150.** Representative examples of circuit elements that can emit a problematic level of EMI **150** include voltage controlled oscillators ("VCOs"), phased-lock loops ("PLLs"), amplifiers, and other active or passive circuit components (not an exhaustive list).

One technique for actively addressing signal interference involves sampling the aggressor signal and processing the acquired sample to generate an emulation of the interference, in the form of a simulated or emulated interference signal. A canceller circuit subtracts the emulated interference signal from the received victim signal (corrupted by the interference) to yield a compensated or corrected signal with reduced interference.

Conventional technologies for obtaining a representative sample of the aggressor signal, or of the interference itself, are frequently inadequate. Sampling distortion or error can lead to a diminished match between the interference and the emulation of the interference. One technique for obtaining a sample of the aggressor signal is to directly tap the aggressor line. However, the resulting loss of power on the transmitted aggressor line is detrimental in many applications, such as in hand-held radios, cell phones, or handset applications. Directly tapping into the aggressor line can also adversely impact system modularity.

The interference sampling system should usually be situated in close proximity to the source or sources of interference. This configuration helps the sampling system sample the interference signals while avoiding sampling the radio signal. Inadvertent sampling of the radio signal could result in the canceller circuit removing the victim radio signal from the compensated signal, thereby degrading the compensated signal. In other words, conventional technologies for obtaining an interference sample often impose awkward or unwieldy constraints on the location of the sampling elements.

For handset applications, the sampling system should be compatible with the handset architecture and its compact configuration. Radio handsets, such as mobile phones, typically contain numerous components that design engineers may struggle to integrate together using conventional technologies. Strict placement requirements of conventional interference sampling systems frequently increase system design complexity. In other words, conventional interference sampling systems often fail to offer an adequate level of design flexibility as a result of positioning constraints.

Another shortcoming of most conventional technologies for active EMI cancellation involves inadequate management of power consumption. An active EMI cancellation system may consume an undesirably high level of electrical power that can shorten battery life in handset applications. That is, EMI cancellation technology, when applied in a cellular telephone or another portable device, often draws too much electricity from the battery or consumes too much energy from whatever source of energy that the portable device uses. Consumers typically view extended battery life as a desirable feature for a portable wireless communication product. Thus, reducing power consumption to extend usage time between battery recharges is often an engineering goal, mandate, or maxim.

To address these representative deficiencies in the art, what is needed is an improved capability for addressing, correcting, or canceling signal interference in communication systems. A need also exists for a compact system for sampling an aggressor signal and/or associated interference in a communication system, such as a cellular device. A further need exists for an interference sampling system that affords an engineer design modularity and/or flexibility. Yet another need exists for a system that reduces or suppresses signal interference while managing power consumption. A capability addressing one or more of these needs would support operating compact communication systems at high data rates and/or with improved signal fidelity.

US 5,574,971 A discloses an interference cancellation system for use with a radio system. The disclosed radio system includes a transmitting radio path and a receiving radio path, both being coupled to a common antenna. A reference coupler is coupled to the transmitting radio path and provides a reference signal in response to a signal transmitted at the transmitting radio path. Furthermore, a receiver coupler is coupled to the transmitting radio path and provides a received signal containing a desired signal component as received by the common antenna and an interfering signal component resulting from reflection of the transmitted signal by the common antenna. A cancellation signal is derived from the reference signal and coupled to the receiving radio path in order to cancel the interfering signal component from the received signal.

It is the object of the present invention to provide an improved system and method for reducing interference between a first communication channel and a second communication channel of a communication system.

The object is solved by the subject matter of the independent claims.

Preferred embodiments of the present invention are defined by the dependent claims.

The present invention supports compensating for signal interference, such as EMI or crosstalk, occurring between two or more communication channels or between two or more communication elements in a communication system. Compensating for interference can improve signal quality or enhance communication bandwidth or information carrying capability.

A communication signal transmitted on one communication channel can couple an unwanted interference signal onto a second communication channel and interfere with communication signals transmitting on that second channel. Either channel or each of the channels can comprise a transmission line, an electrical conductor or waveguide, a bus, a medium that provides a signal path, or an active or passive circuit element such as a filter, oscillator, diode, or amplifier (not an exhaustive list). Thus, a channel can be a GSM device, a processor, a detector, a source, a diode, a circuit trace, or a DSP chip, to name a few possibilities.

In addition to occurring between two channels, the interference effect can couple between and among three or more communication channels, with each channel imposing interference on two or more channels and receiving interference from two or more channels. A single physical medium, such as a single segment of wire, can provide a transmission medium for two or more channels, each communicating digital or analog information. Alternatively, each channel can have a dedicated transmission medium. For example, a circuit board or flex cable can have multiple conductors in the form of circuit traces, in which each trace provides a distinct communication channel.

In one aspect of the present invention, a sensor can be disposed in the proximity of one or both channels to obtain a sample or representation of the interference and/or the aggressor signal that produced, induced, generated, or otherwise caused the interference. The sensor can comprise a sensing or sampling channel that obtains the sample. As an aggressor channel transmits communication signals, such as digital data or analog information, producing interference on a victim channel, the sensing channel can sample the aggressing communication signals and/or the interference. The sensing channel can be, for example, a conductor dedicated to obtaining a representation of the aggressing signal or the interference. Such a sensing conductor can be near a conductor carrying aggressing signals, near a conductor carrying victim signals, or in an EM field associated with the aggressing channel and/or the victim channel. The sensing conductor can be physically separated from the aggressing conductor while coupling to the aggressing conductor via an inductive field, a magnetic field, an electrical field, and/or an EM field. That is, the sensing conductor can obtain a sample of the aggressor signal without necessarily physically contacting or directly touching the aggressor conductor, for example.

In another aspect of the present invention, a circuit that cancels, corrects, or compensates for or otherwise address communication interference can have at least two modes of operation. The interference compensation circuit could be coupled to the sensor, for example. In the first mode, the interference compensation circuit can generate, produce, or provide a signal that, when applied to a communication signal, reduces interference associated with that communication signal. In the second mode, the interference compensation circuit can refrain from producing or outputting the interference correction signal. The second mode can be viewed as a standby, idle, passive, sleep, or power-saving mode. Operating the interference compensation circuit in the second mode can offer a reduced level of power consumption.

The discussion of addressing interference presented in this summary is for illustrative purposes only. Various aspects of the present invention may be more clearly understood and appreciated from a review of the following detailed description of the disclosed embodiments and by reference to the drawings and claims.

### BRIEF DESCRIPTION OF THE DRAWINGS

Figure 1 illustrates a functional block diagram of a communication system comprising an interference sensor coupled to an interference compensation circuit according to an exemplary embodiment of the present invention.
Figure 2 illustrates flex circuits that can comprise an integral interference sensor according to an exemplary embodiment of the present invention.
Figure 3 illustrates a functional block diagram of an interference compensation circuit according to an exemplary embodiment of the present invention.
Figure 4 illustrates a frequency plot of an interference signal prior to interference compensation overlaid on a plot of the interference signal following interference compensation according to an exemplary embodiment of the present invention.
Figure 5 illustrates a plot of an interference signal prior to application of interference compensation according to an exemplary embodiment of the present invention.
Figure 6 illustrates a plot of an interference signal following application of interference compensation according to an exemplary embodiment of the present invention.
Figure 7 illustrates an interference compensation circuit that can be coupled to an interference sensor according to an exemplary embodiment of the present invention.
Figure 8 illustrates a flowchart of a process for operating an interference compensation circuit in a plurality of modes according to an exemplary embodiment of the present invention.

Many aspects of the invention can be better understood with reference to the above drawings. The components in the drawings are not necessarily to scale, emphasis instead being placed upon clearly illustrating the principles of exemplary embodiments of the present invention. Moreover, in the drawings, reference numerals designate corresponding, but not necessarily identical, parts throughout the different views.

### DETAILED DESCRIPTION OF EXEMPLARY EMBODIMENTS

The present invention supports canceling, correcting, addressing, or compensating for interference, EMI, or crosstalk associated with one or more communication paths in a communication system, such as a high-speed digital data communication system in a portable radio or a cellular telephone. An interference sensor can obtain a signal representation or a sample of a communication signal that imposes interference or of the interference. The interference sensor can be integrated into a structure, such as a flex circuit or a circuit board, that supports or comprises at least one conductor that imposes or receives the interference. In an exemplary embodiment, the interference sensor can be a dedicated conductor or circuit trace that is near an aggressor conductor, a victim conductor, or an EM field associated with the EMI. The sensor can be coupled to an interference compensation circuit. The interference compensation circuit can have at least two modes of operation. In the first mode, the circuit can actively generate or output a correction signal. In the second mode, the circuit can withhold generating or outputting the correction signal, thereby conserving power and/or avoiding inadvertently degrading the signal-to-noise ratio of the involved communication signals.

Turning to discuss each of the drawings presented in Figures 1-8, in which like numerals indicate like elements, an exemplary embodiment of the present invention will be described in detail.

Referring now to Figures 1 and 2, Figure 1 illustrates a functional block diagram of a communication system **100** comprising an interference sensor **115, 125** coupled to an interference compensation circuit **130** according to an exemplary embodiment of the present invention. Figure 2 illustrates flex cables or flex circuits that can comprise one or both of the data buses **110, 120** illustrated in Figure 1 and that can be adapted in accordance with an exemplary embodiment of the present invention to comprise an interference sensor. In an exemplary embodiment, a cellular telephone or some other portable wireless device can comprise the communication system **100.**

A DSP chip 135 connects to a display **140** and a camera **145** via two data busses **110,120** or channels. Digital data flowing on the data busses **110, 120** causes, induces, and/or is the recipient of interference **150,** such as EMI. Beyond the data busses **110, 120,** a channel receiving or causing interference can comprise the display **140,** and/or the radio system **105.** As will be appreciated by those skilled in the art, the victim radio system **105** handles communication signals in connection with transmission over a wireless network.

In an exemplary embodiment, a flex circuit **200,** as illustrated in Figure 2, comprise the data busses **110, 120.** The flex circuit **200** typically comprises a polymer, plastic, or dielectric film that is flexible and further comprises conductive circuit traces deposited on or adhering to the film substrate. Conductors can be laminated between two pliable films, for example. The data buses **110, 120** can be embodied in one or more ribbon cables.

The communication system **100** comprises an interference compensation or correcting circuit **130,** depicted in the exemplary form of an integrated circuit 130. The interference compensation circuit **130,** described in further detail below, delivers an interference compensation signal into or onto a channel that is a recipient of interference, to cancel or otherwise compensate for the received interference. The interference compensation signal is derived or produced from a sample of an aggressor communication signal that is propagating on another channel, generating the crosstalk.

The interference compensation circuit **100** can be coupled between the channel **110, 120** that generates the interference **150** and the device **105** that receives the interference **150.** In this configuration, the interference compensation circuit **130** can sample or receive a portion of the signal that is causing the interference and can compose the interference compensation signal for application to the victim device **105** that is impacted by the unwanted interference **150.** In other words, the interference compensation circuit **110, 120** can couple to the channel **110, 120** that is causing the interference **150,** can generate an interference compensation signal, and can apply the interference compensation signal to the recipient **105** of the interference to provide interference cancellation, compensation, or correction.

A battery, not shown on Figure 1, typically supplies energy or power to the interference compensation circuit **130** as well as the other components of the system **100.** As an alternative to a battery, a fuel cell or some other portable or small energy source can supply the system **100** with electricity. As discussed in more detail below, the system **100** and specifically the interference compensation circuit **130** can be operated in a manner that manages battery drain.

The interference compensation circuit **130** can generate the interference compensation signal via a model of the interference effect. The model can generate the interference compensation signal in the form of a signal that estimates, approximates, emulates, or resembles the interference signal. The interference compensation signal can have a waveform or shape that matches the actual interference signal. A setting or adjustment that adjusts the model, such as a set of modeling parameters, can define characteristics of this waveform.

The interference compensation circuit **130** receives the signal that is representative of the aggressor signal (or alternatively of the interference itself) from a sensor **115, 125** that is adjacent one or both of the data busses **110, 120.** In an exemplary embodiment, the sensor **115, 125** comprises a conductor, associated with one or both of the data bus channels **110, 120,** that is dedicated to obtaining a sample of the aggressor signal. For example, the data bus **110** can have a plurality of conductors that transmit data between the camera **145** and the DSP chip **135** and at least one other conductor that senses, sniffs, or samples the aggressor signal, or an associated EM or EMI field, rather carrying data for direct receipt. For example, one of the data bus conductors can function as a sensor during a time interval when that specific conductor is not conveying purposeful data.

In an exemplary embodiment, the sensor **115, 125** is integrated into a common structure to which the conductors of the data bus **110, 120** adhere or are attached. For example, the sensor **115, 125** can be attached to a flex cable **200.** In one exemplary embodiment, the sensor **115, 125** comprises a conductive trace deposited on the flex cable **200.** In one exemplary embodiment, the sensor **115, 125** couples to the communication signals propagating on the data bus **110, 120** via the EM field of those signals. For example, the coupling can be via induction rather than through a direct contact that could transmit direct current ("DC") energy or signals below a threshold frequency. Thus, the sensors **115, 125** can be isolated from the aggressor channel below a threshold frequency and coupled to the aggressor channel above a threshold frequency.

The sensor **115, 125** can be formed into or integrated with the flex cable **200** at the time that the flex cable **200** is manufactured, for example as a step in a manufacturing process that involves lithography: The flex cable **200** can alternatively be adapted following its manufacture, for example by adhering the sensor to the flex cable **200.** That is, a conventional flex cable can be acquired from a commercial vendor and processed to attach the sensor **115,125** to that cable.

In one exemplary embodiment of the present invention, the sensor **115, 125** comprises an interference sampler located in close proximity to an interference source. In another exemplary embodiment of the present invention, the interference compensation circuit **130** samples its reference signal from a conductor that is in the vicinity of a victim antenna. In yet another exemplary embodiment of the present invention, the interference sensor **115, 125** comprises a sampling mechanism embedded as a lane within the bus path **110, 120** of the interference source. For example, the sampling mechanism can comprise an additional conductive line running parallel to the other data lines in a flex cable, or in a rigid printed circuit board. Embedding the sampling mechanism can provide compact size, design flexibility, modularity, signal integrity, and minimal power draw from the sensed line, which are useful attributes for a successful sampling mechanism and EMI canceller or interference cancellation/compensation system.

Embedding or integrating the sensor **115, 125** or sampling mechanism in a unitary, monolithic, or integrated structure that comprises the bus path **110, 120** provides close proximity between the sensor **115, 125** and the interference source or sources. The resulting close proximity facilitates strong sampling of the interference relative to the radio signal.

Embedding or integrating the sensor **115, 125** with the bus path **110, 120** offers the system designer (and PCB board designer in particular) design flexibility. For example, the design engineer can be freed from the constraint of allocating board space near the interference source for the sampling mechanism, as would be required for an antenna implementation. The system designer can receive relief from the task of designing an antenna according to one or more specific reception requirements, such as a field pattern and a frequency range.

An integrated- or embedded-sensor solution based on dedicating a conductor **115,125** of a multi-conductor bus **110,120** to sensing can have an inherent capability to receive the EMI interference. The inherent receptivity can mirror the inherent emission properties of the other conductors that generate interference. In other words, since emission and reception are typically congruent phenomena, configuring the sensing conductor to have a form similar to the radiating conductor (aggressor) can provide inherent reception of the EMI frequencies of interest.

In one exemplary embodiment of the present invention, the embedded interference sensor **115, 125** can run, extend, or span the entire length of the data bus **110,120** that has data lines emitting the aggressing EMI.

In one exemplary embodiment of the present invention, an interference sensing conductor **115** can extend a limited portion of the total span of the data bus **110, 120,** thereby helping the data bus **110, 120** maintain a compact width. Another exemplary embodiment which can minimize the width of the data bus has the sampling mechanism **115, 125** crossing over or under the data lines **110, 120.** The crossing can be a perpendicular crossing. The sensing conductor and the data conductors can form an obtuse angle or an acute angle, for example.

As illustrated in Figure 1, the sensing conductor **115, 125** can be disposed at a terminal end of the data bus **110, 120.** For example, the sensing conductor **115** can comprise a conductive line near the electrical connection ports between the DSP chip **135** and a flex cable **200** that comprises the data bus **110.** Such a conductor can extend over, under, and/or around the bus, for example as a conductive band.

In one exemplary embodiment of the present invention, the embedded interference sensor **115** receives EMI interference not only from a primary element, such as its associated data bus **110,** but also from other sources on the handset, such as the display **140,** the camera **145,** the DSP **135,** etc. Thus, a single sensor **115** can sample multiple sources of interference to support correcting the interference from two or more sources via that single sensor and its associated interference compensation circuit **130.**

In one exemplary embodiment of the present invention, the interference compensation circuit **130** samples its reference signal (i.e. the aggressor source) from a conducting element **115, 125** that receives radiated EMI **150.** This sampling approach can sense the EMI **150** (or a filtered version thereof), or the aggressor signal in a non-intrusive manner. Specifically, the aggressor data line/source can remain essentially undisturbed physically. The data bus **110, 120** can function with little or no loss of power associated with the sensor **115, 125** inductively coupled thereto, typically without physical contact or direct electrical contact. That is, a dielectric material can separate the sensing conductor **115, 125** from the aggressor conductor, while providing inductive or EM coupling.

After sampling the reference signal, the interference compensation circuit **130** generates a compensation or cancellation signal which is adjusted in magnitude, phase, and delay such that it cancels a substantial portion of the interference signal coupled onto the victim antenna. In other words, the reference signal, which comprises the sample, is filtered and processed so it becomes a negative of the interference signal incurred by the received victim signal. The parameters of the magnitude, phase, and delay adjustment are variable and can be controlled to optimize cancellation performance.

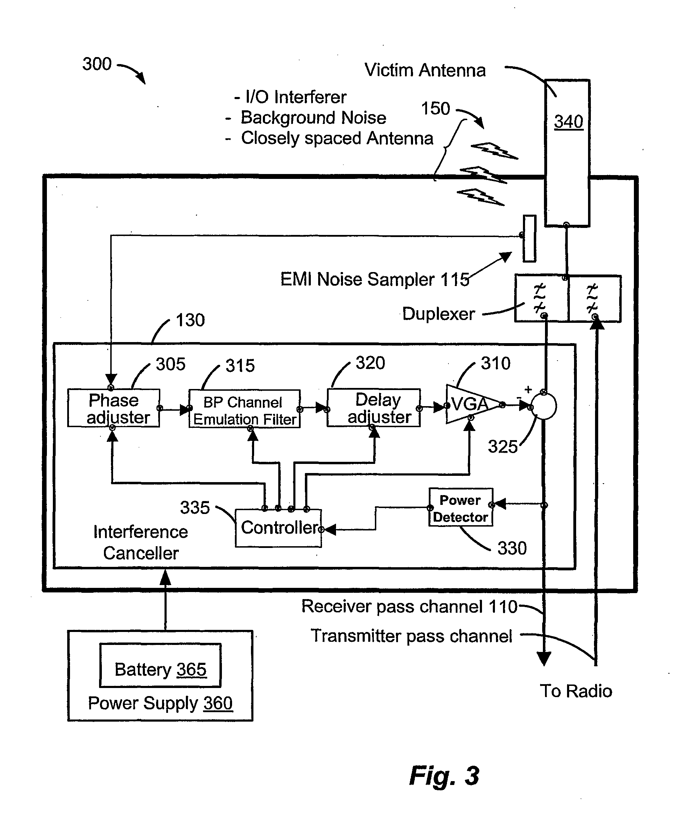

Turning now to Figure 3, this figure illustrates a functional block diagram of an interference compensation circuit 130 according to an exemplary embodiment of the present invention. The interference compensation circuit 130 shown in Figure 3 can be embodied in a chip format as an integrated circuit ("IC"), as illustrated in Figure 1, or as a hybrid circuit. Alternatively, the interference compensation circuit **130** can comprise discrete components mounted on or attached to a circuit board or similar substrate. Moreover, in one exemplary embodiment of the present invention, the system **100** that Figure 1 illustrates can comprise the system **300** of Figure 3.

The interference compensation circuit **130** draws or obtains power or energy from the power supply **360,** and its associated battery **365.** As will be discussed in further detail below, the interference compensation circuit **130** can operate in a plurality of modes, each having a different level of consumption of battery energy.

Figure 3 illustrates representative function blocks of the interference compensation circuit **130,** including a Variable Phase Adjuster **305,** a Variable Gain Amplifier ("VGA") **310,** an emulation filter **315,** a Variable Delay Adjuster **320,** a Summation Node **325,** a power detector, and a controller **335.**

The interference sensor **115** obtains a sample of the aggressor signal via coupling of the interference field, as discussed above, from the receiving channel **110.** The sampled reference signal is fed through the compensation circuit **130** starting with the Variable Phase Adjuster **305.** The phase adjuster's role is to match, at the summation node **325,** the phase of the emulated compensation signal with the phase of the interfering signal coupled onto the victim antenna **340.** That is, the phase adjuster **305** places the phase of the compensation signal in phase with respect to the phase of the interference so that, when one is subtracted from the other, the compensation signal cancels the interference. The cancellation occurs at the summation node **325** by subtracting the coupled signal onto the victim antenna **340** from the emulated signal generated by the interference compensation circuit **130** using the sampled reference signal (from the sensor **115).**

In an alternative embodiment of the compensation circuit **130,** the phase adjuster 305 can adjust the emulated signal phase to be **180** degree out of phase with the interfering coupled signal. In that case, the summation node **325** adds the two signals rather than performing a subtraction.

In one exemplary embodiment, the phase shifter **305** comprises quadrature hybrids, and four silicon hyper-abrupt junction varactor diodes, along with various resistors, inductors and capacitors for biasing, pull-up, and signal conditioning. In another exemplary embodiment, the phase shifter **305** comprises an active circuit.

The emulation filter **315** follows the variable phase shifter **305** in the cancellation path. The emulation filter **315** is typically a band pass ("BP") filter that models the channel coupling and is also tunable in order to compensate for any drifts in channel center frequency.

In one exemplary embodiment, the emulation filter **325** comprises lumped elements and varactor diodes. The varactor diodes help change or control the center frequency of the emulation channel.

In one exemplary embodiment, the emulation filter **325** is a Finite Impulse Filter ("FIR"). The FIR can comprise taps and tap spacings that are extracted from or determined according to the coupling channel characteristics. In order to have robust cancellation for improved signal integrity of the communication system **100,** the emulation filter **325** typically should match, in trend, the coupling channel characteristics within the frequency band of interest.

The next component in the cancellation path is the controllable delay adjuster 320, whose main role is to provide a match between the group delay of the coupled signal through the victim antenna **340** and the group delay of the emulated compensation signal at the summation node **325.**

The output of the delay adjuster **320** feeds into the VGA **310.** The VGA **310** matches the emulated signal's amplitude to the amplitude of the interference signal at the summation node **325.** Whereas the emulation filter **315** models the frequency characteristics (i.e. attenuation of frequencies relative to other frequencies) of the coupling channel, the VGA **310** applies a broadband gain, which is constant in magnitude across the frequency band of interest. Thus, the emulation filter **315** and the VGA **310** function collaboratively to match the magnitude of the channel's coupling response on an absolute scale, rather than merely a relative scale.

The VGA 310 feeds the interference compensation signal to the summation node **325.** In turn, the summation node **325** applies the compensation signal to the victim channel to negate, cancel, attenuate, or suppress the interference.

In one exemplary embodiment, the summation node **325** comprises a directional coupler. In an alternative exemplary embodiment, the summation node **325** comprises an active circuit such as a summer, which is typically a three-terminal device, or an output buffer, which is typically a two-terminal device.

For best performance, the summation node **325** should introduce essentially no mismatch to the victim antenna signal path. That is, the summation node **325** should ideally maintain the 50-ohm impedance characteristic of the system **130.** Nevertheless, in some situations, small or controlled levels of impedance mismatch can be tolerated. Avoiding impedance mismatch implies that the summation node **325** should have a high output impedance at the tap. Additionally, the summation node **325** should not add significant loss to the victim antenna receive path, as such loss can adversely affect receiver sensitivity. For illustrative purposes, this discussion of impedance matching references a system with a characteristic impedance of 50-ohms; however, exemplary embodiments of the present invention can be applied to systems with essentially any characteristic impedance.

While Figure 3 illustrates the components **305, 310, 315, 320** is a particular order, that order is exemplary and should not be considered as limiting. Moreover, the order of those components **305, 310, 315, 320** is usually not critical and can be changed, or the components **305, 310, 315, 320** can be rearranged, while maintaining acceptable performance of the interference compensation circuit **130.**

The interference compensation circuit **130,** which can be viewed as an EMI canceller, offers flexibility in that the cancellation or compensation parameters can be adjusted or controlled to optimize the match of the emulated coupling channel to the actual EMI coupling channel. More specifically, the controller **335** and its associated power detector **330** provide a feedback loop for dynamically adjusting the circuit elements **305, 310, 315, 320** in a manner that provides robust correction of interference.

Two methods for controlling these parameters are described in U.S. Provisional Patent Application Serial No. 60/689,467, entitled "Automatic Gain and Phase Control for an Interference Cancellation Device" and filed on June 10, 2005 in the name of Kim et al. and U.S. Provisional Patent Application Serial No. 60/696,905, entitled "Control Loop for Active Noise Canceller in Wireless Communication System" and filed on July 6, 2005 in the name of Schmukler et al. The entire contents of U.S. Provisional Patent Application Serial Nos. 60/689,467 and 60/696,905 are hereby incorporated herein by reference. Thus, an exemplary embodiment of the present invention can comprise any of the technologies, teachings, systems, methods, processes, or disclosures of U.S. Provisional Patent Application Serial Nos. 60/689,467 and 60/696,905.

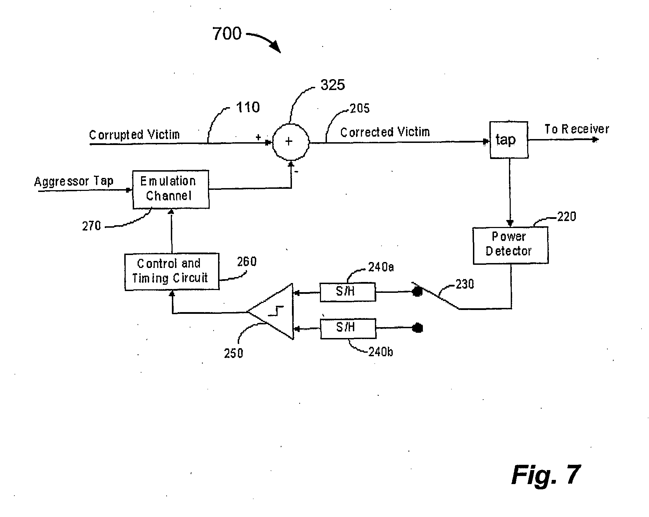

Referring now to Figure 7, this figure illustrates an interference compensation circuit **700** that can be coupled to an interference sensor **115, 125** according to an exemplary embodiment of the present invention. In other words, in one exemplary embodiment, the system **100** illustrated in Figure 1 and discussed above can comprise the circuit **700** rather that the circuit **130.** U.S. Provisional Patent Application Serial No. 60/696,905, entitled "Control Loop for Active Noise Canceller in Wireless Communication System" and filed on July 6, 2005 in the name of Schmukler et al. provides additional information about the circuit **700** to supporting using that circuit 700 in an exemplary embodiment of the present. The contents of U.S. Provisional Patent Application Serial No. 60/696,905 are hereby included herein by reference.

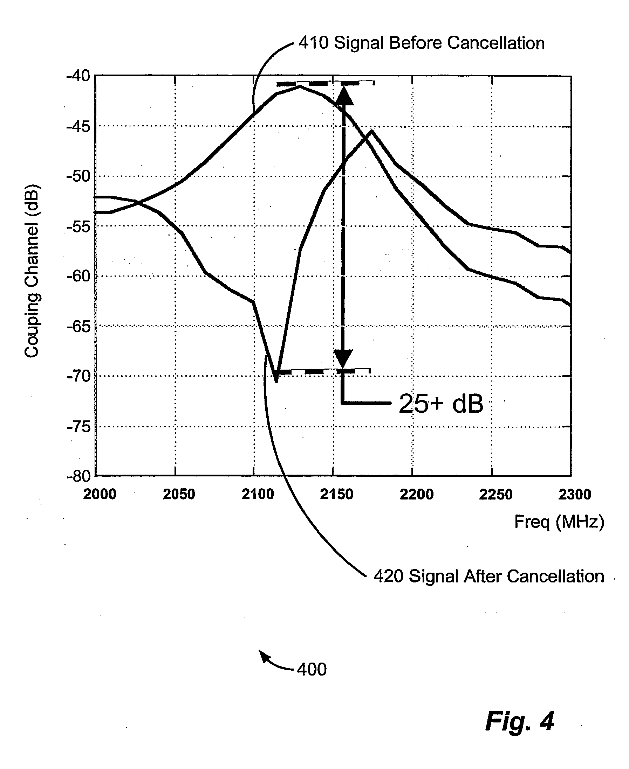

Turning now to Figure 4, this figure illustrates a frequency plot **410** of an interference signal prior to interference compensation overlaid upon a plot **420** of the interference signal following interference compensation according to an exemplary embodiment of the present invention. That is, the graph **400** illustrates laboratory test data collected before and after an application of interference compensation in accordance with an exemplary embodiment of the present invention.

More specifically, Figure 4 shows the coupling channel characteristics between a flex cable, similar to the flex cables **200** illustrated in Figure 2 and discussed above, and a 2.11 gigahertz ("GHz") antenna. The test data shows that, in laboratory testing, an exemplary embodiment of an interference compensation circuit **130** achieved a signal reduction greater than 25 dB in the frequency band between 2.1 GHz and 2.15 GHz.

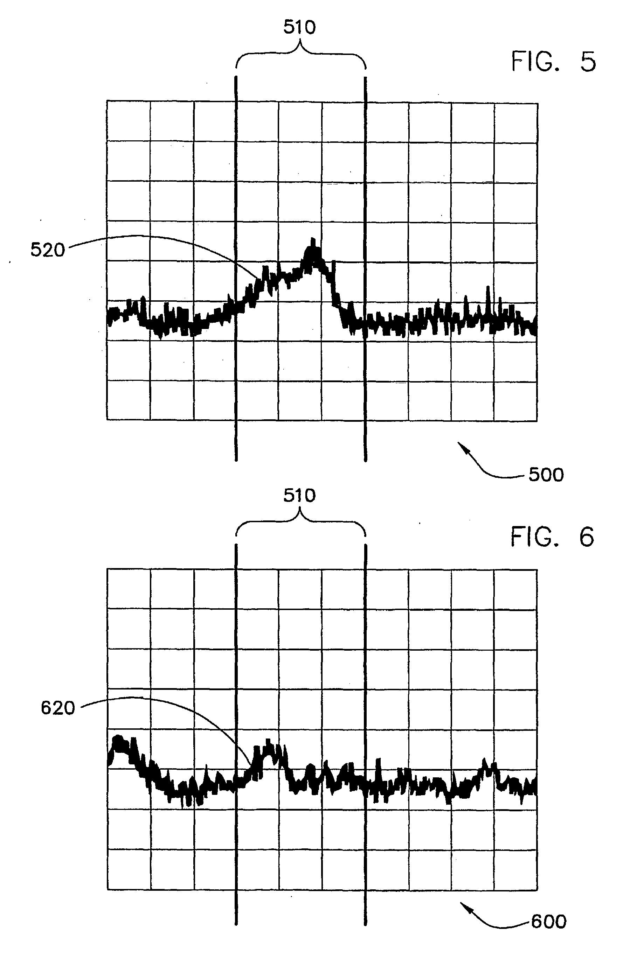

Turning now to Figures 5 and 6, these figures respectively show spectral plots **500, 600** before and after applying interference compensation according to an exemplary embodiment of the present invention. More specifically, the traces **520, 620** of these plots **500, 600** illustrate data obtained in laboratory testing of an interference compensation system in accordance with an exemplary embodiment of the present invention.

The spectra **520, 620** characterize a 450 megabits-per-second ("Mbps") (PRBS-31) interfering signal coupled onto a 2.1 GHz antenna that is in close proximity to a flex cable carrying the 450 Mbps signal. In the frequency band of interest **510,** the compensation achieved approximately 12 dB of interference suppression.

Referring now to Figures 1, 2, and 3, the interference compensation circuit **130** can function or operate in at least two modes. In one mode, the circuit **130** can consume less power than in the other mode. That is, the interference compensation circuit **130** can transition from an active mode of relatively high power usage to an other mode of relatively low power usage. The other mode can be a standby mode, a power-saving mode, a passive mode, an idle mode, a sleep mode, or an off mode, to name a few possibilities. In that other mode, the interference compensation circuit can draw a reduced level of power, minimal power, essentially no power, or no power at all. Part or all of the interference compensation circuit illustrated in Figure 3 and discussed above can be disconnected from power in the other mode. An occurrence of one criterion or multiple criteria or conditions can trigger a transition from active compensation to a standby mode. Thus, the transition can occur automatically in response to an event other than a user turning off an appliance, such as a cell phone, that comprises the circuit **130.**

In a handset application, operating the interference compensation circuit **130** in a power-saving mode can extend the operation time of a single battery charge, thereby enhancing the commercial attractiveness of the handset. Power reduction can be implemented or achieved without degrading interference compensation performance.

Conditions occur in wireless handset devices that provide an opportunity for reduced power consumption. In particular, many of the EMI sources are not always active and, therefore, are not always emitting interference. In situations in which the interference compensating circuit **130** and its associated controller **335** do not need to apply a compensation signal, the circuit **130** can transition to a sleep or stand-by mode of reduced power consumption. That is, rather than having one or more circuit elements receiving power while not producing an output or actively manipulating signals, power can be removed from those elements or from a selected set of circuit elements.

Thus, in one exemplary embodiment of the present patent invention, the system **100** experiences states in which operating certain components of the interference compensation circuit **130** is unnecessary. In such states, the controller **335** can place those components in a low-power or standby mode or can remove power entirely from those components. For example, when an EMI source is not active for a threshold amount of time, the interference compensation circuit **130** can transition to the standby mode. More specifically, when the bus **110** is not actively carrying data traffic, the interference compensation circuit **130** can switch to the standby mode to conserve battery power.

In one exemplary embodiment, the sensor **115** provides a signal that is indicative of whether the bus **110** is active. That is, the level, voltage, amplitude, or intensity of the signal that the sensor **115** output can provide an indication of whether the bus is actively transmitting aggressor signals.

When appropriate conditions are met, electrical power can be removed from the components **305, 310, 315, 320** that generate the emulated EMI signal. And, power can additionally or optionally be removed from some or all of the circuitry of the control module **335.** However, components used to store the emulation characteristics or parameters, i.e. the emulation channel settings that match the coupling channel, can be kept active so as to immediately or quickly restore the interference compensation circuit's emulation channel to its last known state when the EMI source (e.g. the aggressor channel **110)** is reactivated. In other words, the memory system of the controller **335** can retain power access to avoid loss of the parametric values stored in memory. Keeping the parametric values in memory facilitates rapid restoration to active cancellation upon reactivation of the EMI source. Thus, recalling the operational settings of the phase adjuster **305,** the emulation filter **315,** the delay adjuster **320,** and the VGA **310** avoids the interference that would occur if the emulation was retrained from an arbitrary reset state following transition from standby mode to active mode.

Operating in the standby mode can comprise either full powering down one or more circuit components and/or operating in a state of reduced power usage. In some instances, the latter may be preferred in order to rapidly bring the component out of the standby state when the EMI source is reactivated.

In one exemplary embodiment of the present invention, a standby signal instructs or triggers the interference compensation circuit **130** to transition to its power-saving or standby state. The standby signal can also trigger the transition from the power-saving or standby state to an active state. A device transmitting the source of the EMI, or an associated power detector, can generate a signal indicating that it is actively transmitting data. For example, the DSP chip 135 that sends data to the display **140** in the mobile phone system **100** can output an binary signal or code to indicate that it not transmitting data and consequently emitting EMI.

As another example, the camera imaging sensor **145** that sends data to a the DSP chip **135** can output a binary signal or a digital code to indicate whether or not it is transmitting data that could produce EMI. As yet another example, a radio device that uses time-division multiplexing can provide the triggering standby signal. Such a radio device can be used in GSM or wideband code division multiple access ("W-CDMA") applications, for example. In this situation, the radio may output a binary signal to mark the time divisions or intervals in which it is transmitting data. During those portions of the duplexing stage, the interference compensation should be active, as the transmitted signal can aggress a second radio device on a wireless handset.

In one exemplary embodiment of the present invention a power detector, such as the detector **330,** examines the sampled EMI signal and generates the standby signal based on properties of the sampled EMI signal. For example, a standby state can be set if the detector **330** determines that power of the sampled EMI signal is below a given or predetermined threshold. Conversely, the interference compensation circuit **130** can be activated when the detected power moves above the threshold.

In one exemplary embodiment of the present invention, the standby state can be declared if the time-localized peak amplitude of the sampled EMI signal falls below a given threshold. One advantage of this embodiment is that its implementation does not typically require an extra pin on the device package to be fed a dedicated standby signal. Instead, the standby signal could be derived from an available pin already used for EMI cancellation.

In one exemplary embodiment of the present invention, all the components **305, 310, 315, 320** of the emulation channel that are used to generate the emulated EMI signal from the sensor's sampled EMI source signal can be placed in the low-power standby state. In one exemplary embodiment of the present invention, one or more of the following components are placed in standby mode in response to an occurrence of a standby condition: the phase adjuster **305,** the BP channel emulation filter **315,** the delay adjuster **320,** and the VGA **310.** Reducing power consumption of those devices components **305, 310, 315, 320** facilitates significant power savings when the EMI source is inactive.

The controller **335,** which can also be referred to as a control module, can be inactive when the EMI source is inactive. With no source of EMI and an inactive controller **335,** interference is not typically problematic. More specifically, no EMI occurs, and the emulation path is producing a zero emulation signal. In many circumstances, an improvement in interference performance can result from deactivating the emulation path when no source of EMI is active. If the emulation channel remains active when no EMI source is active, the emulation channel parameters may drift towards a set of values that poorly match the underlying EMI coupling channel. In this situation, activating the EMI source can result in poor tuning that causes the interference compensation circuit **130** to learn new, more effective parameters. In other words, when the interference compensation circuit **130** is inactive, an improperly tuned coupling channel can still produce a zero emulation signal since the sampled EMI source signal will be zero.

In one embodiment of the present invention, all of the components, or essentially all of the active components, of the control module can be placed in the standby state when the standby signal is asserted, thereby providing a high level of power savings.

In one exemplary alternative embodiment of the present invention, the register or memory elements used to store the controllable parameters in the emulation channel are fully powered, while the rest of the control module **335** is deactivated. This embodiment facilitates rapidly or immediately returning the emulation channel to its pre-standby state when the system exits the standby mode. In other words, once the system leaves standby mode, the interference compensation circuit **130** can resume cancellation from a previously-known and accurate channel model, rather than starting the cancellation from an arbitrary reset state. Resuming operation of the interference compensation circuit 130 from an arbitrary set of parameters may take an undesirably long period of time prior to convergence to an accurate channel model. During this learning time, EMI cancellation performance may be insufficient or inadequate.

Referring now to Figure 7, the interference compensation circuit **700** can operate in two or more modes, one of which offers reduced power consumption relative to the other. In other words, in one exemplary embodiment of the present invention, the circuit **700** transitions to a power-saving mode upon occurrence of a trigger event. In that mode, power can be removed from one or more of the power detector **220,** the switching device **230,** the sample and hold circuits **240a** and **240b,** and the comparator **250.** The power detector **220** and comparator **250** are two leading contributors to power consumption, thus disconnecting their power supply can achieve significant power savings. The control and timing circuit **260** typically comprises low-speed digital logic that consumes negligible power. Nonetheless, most of this circuit **260** can be deactivated with the exception of the registers, which store the values of the emulation channel **270** parameters.

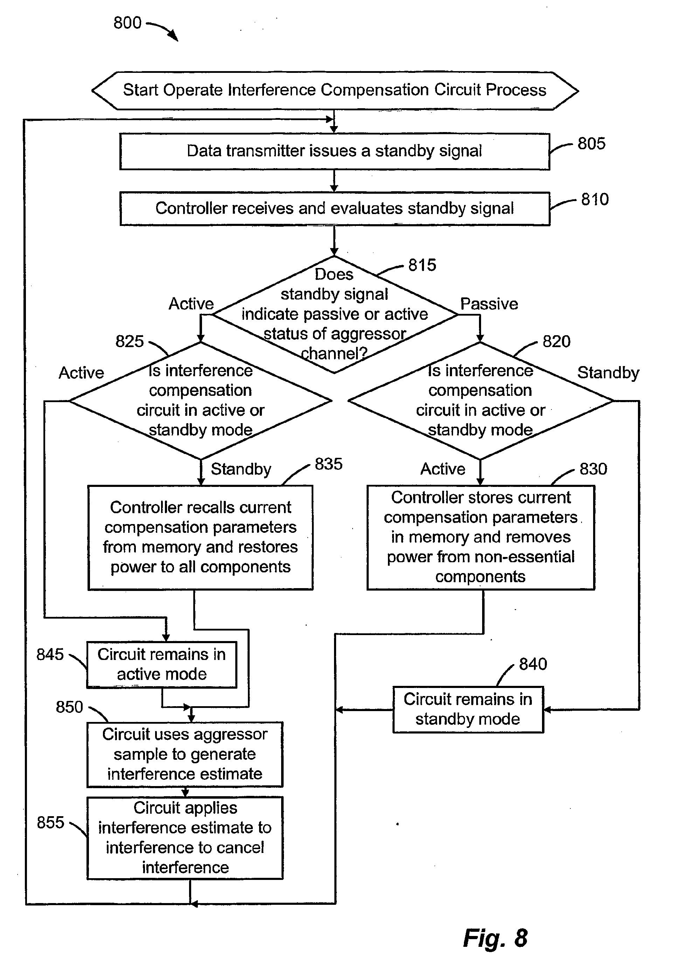

Turning now to Figure 8, this figure illustrates a flowchart of a process **800** for operating an interference compensation circuit **130** in a plurality of modes in accordance with an exemplary embodiment of the present invention. The Process 800, which is entitled Operate Interference Compensation Circuit, can be viewed as a process for managing power consumption of an interference compensation circuit **130.**

At Step **805,** a data transmitter, such as the camera **145** or the DSP chip **135** issues a standby signal that can comprise a digital code. The code carries the status of the transmitter, for example whether the transmitter is actively transmitting data or is in a passive state between two time periods of data transmission. In one embodiment, the code specifies whether the transmitter is preparing to actively transmit data or to change between operational states.

At Step **810,** the controller **335** receives the standby signal and determines whether the transmitter is in an active state of transmitting data or a passive state. Decision Step **815** branches the flow of Process **800** to Step **825** if the standby signal indicates that the transmitter is active. If, on the other hand, the standby signal indicates that the transmitter is passive, then decision Step **820** follows Step **820.**

At decision Step **820,** the controller **335** determines whether the interference compensation circuit **130** is in an active mode or is otherwise in a passive mode. If the interference compensation circuit **130** is in an active mode, then Step **830** follows Step **820.**

At Step **830,** the controller **335** stores the current or present compensation parameters in memory and removes power from the emulation channel components **305, 310, 315, 320.** This action places the interference compensation circuit **130** in a standby or power-saving mode. The stored compensation parameters typically comprise the settings of each of the adjustable components **305, 310, 315, 320** of the emulation channel.

If at decision Step **820,** the controller **335** determines that the interference compensation circuit **130** is in the standby mode rather than the active mode, then Step **840** follows Step **820.** At Step **840,** the interference compensation circuit **130** remains in the standby mode.

If decision step **815** branches the flow of Process **800** to Step **825** rather than Step **820** (based on the standby signal indicating active data transmission), then at decision Step **825,** the controller **335** determines whether the interference compensation circuit **130** is in active mode or standby mode.

If the interference compensation circuit **130** is in active mode, then Step **845** follows Step **825.** At Step **845,** the interference compensation circuit **130** remains in active mode.

If the controller **335** determines at decision Step **825** that the interference compensation circuit **130** is in standby mode rather than active mode, then Step **835** follows Step **825.** At Step **835,** the controller **335** recalls the current or last-used compensation parameters from memory and restores power to the powered-down components. Restoring power typically comprises initializing each of the adjustable components **305, 310, 315, 320** of the emulation channel with the parametric settings recalled from memory.

Step **850** follows execution of either of Steps **835** and **845.** At Step **850,** the interference compensation circuit **130** generates an estimate of the interference based on processing the aggressor sample, which the sensor **115** obtained. As discussed above with reference to Figure 3, the emulation channel components **305, 310, 315, 320** process the sample to output the interference estimate.

At Step **855,** the interference compensation circuit **130** applies the interference estimate to the victim channel to cancel, suppress, or correct the interference occurring thereon.

Following execution of any of Steps **830, 840,** and **855,** Process **800** loops back to and executes Step **805** as discussed above. Execution of Process **800** continues following the loop iteration.

In summary, a system in accordance with an exemplary embodiment of the present invention can comprise a sensor that obtains a representative interference sample or a sample of an interfering signal. A system in accordance with an exemplary embodiment of the present invention can alternatively, or also, comprise a circuit that operates in two or more modes to cancel, correct, or compensate for interference imposed on one communication signal by another signal. The system can be applied to wireless communication devices, such as cell phones, personal data assistants ("PDAs"), etc. However, those skilled in the art will appreciate that the present invention is not limited to the described applications and that the embodiments discussed herein are illustrative and not restrictive. Furthermore, it should be understood that various other alternatives to the embodiments of the invention described here may be recognized by those skilled in the art upon review of this text and the appended figures. Such embodiments may be employed in practicing the invention. Thus, the scope of the present invention is intended to be limited only by the claims below.

## Claims

1. A system (100) for handling communication signals, comprising:
a first channel (110, 120), operative to transmit first communication signals from a first signal source (135, 145) within the system to a first receiver (135, 140) within the system;
a second channel operative to receive second communication signals and to receive interference from the transmitted first communication signals; and
a third channel (115, 125), inductively coupled to the first channel, operative to sense the first communication signals for input to an interference compensation circuit;
characteized in that
the first channel (110, 120) comprises a first conductor attached to a substrate, the second channel comprises a second conductor attached to the substrate, the third channel (115, 125) comprises a third conductor attached to the substrate and separated from each of the first conductor and the second conductor and the third conductor comprises a conductive segment extending parallel and in close proximity to the first conductor.

2. The system (100) of Claim 1, wherein the system comprises the interference compensation circuit (130), and wherein the interference compensation circuit is operative to function in an active mode for applying interference compensation and a standby mode.

3. The system (100) of Claim 1, wherein the system further comprises a power source connected to the interference compensation circuit, and
wherein the interference compensation circuit (130) is operative to operate in each of an active mode and a passive mode and to obtain more power from the power source in the active mode than in the passive mode.

4. The system (100) of Claim 1, further comprising the interference compensation circuit (130),
wherein the interference compensation circuit is operative in a first mode to output an interference compensation signal based on the sensed first communication signals, and
wherein the interference compensation circuit is operative in a second mode to suspend outputting the interference compensation signal while consuming at least some power.

5. The system (100) of claim 1, wherein the first channel (110, 120) comprises a first conductor, wherein a second receiver (105) is comprised in the second channel and is operative to receive the second communication signals, and wherein the third channel (115, 125) comprises a second conductor.

6. The system (100) of Claim 5, further comprising a sheet of dielectric material, wherein the first conductor and the second conductor are embedded in the dielectric material, and wherein the second conductor is inductively coupled to the first conductor and is isolated from the first conductor in at least some frequency range.

7. The system (100) of Claim 5, wherein the first conductor and the second conductor are disposed along a common plane and are separated from one another by at least some distance.

8. The system (100) of Claim 5, wherein the first conductor and the second conductor are disposed on a flexible film.

9. The system (100) of Claim 5, wherein the second conductor is inductively coupled to the first conductor and is disposed across the first conductor.

10. The system (100) of Claim 5, further comprising:
a data bus, comprising the first conductor (110, 120); and
a radio antenna comprised in the second channel.

11. The system (100) of Claim 5, wherein:
the first signal source comprises an imaging device (140);
the first receiver comprises a processor (135);
the first signals comprise digital signals;
the second signals comprise wireless signals;
the second channel comprises an antenna; and
the system further comprises a circuit (130), connected to the second conductor, operative to receive the sampled first transmitted signals and to output third signals to the second receiver for canceling the coupled interference.

12. The system of Claim 5, further comprising a dielectric material, disposed between the first conductor and the second conductor, operative to isolate the second conductor from direct current propagating on the first conductor, wherein the second conductor is inductively coupled to the first conductor for sampling the first transmitted signals.

13. The system of Claim 5, further comprising a circuit (130), connected to the second conductor, operative to output an interference correction signal if the sampled first signals are above a threshold and to suspend outputting the interference correction signal if the sampled first signals are below the threshold.

14. The system of Claim 5, further comprising an integrated circuit, coupled to the second conductor, operative to apply interference correction to the second receiver based on the sampled first transmitted signals, and further operative to transition to a standby mode in response to one of the first signal source, the first receiver, and the second receiver transitioning to an inactive state.

15. A method for reducing interference between a first communication channel and a second communication channel of a communication system, the method comprising the steps of:
generating an interference compensation signal, based on an estimate of interference inductively coupled to a third communications channel from a first communications channel, using a circuit;
applying the interference compensation signal to a second communication channel to reduce the interference;
determining whether the first communication channel is in an active state; and
if the first communication channel is not in the active state, placing at least a portion of
the circuit in a standby mode,
**characterized in that**
the first channel comprises a first conductor attached to a substrate, the second channel comprises a second conductor attached to a substrate, and the third channel comprises a third conductor attached to the substrate, separated from each of the first conductor and the second conductor, and extending parallel and in close proximity to the first conductor.

16. The method of Claim 15, wherein the generating step further comprises the circuit drawing a first level of power from a power source,
wherein the method further comprises the step of, in response to placing at least the portion of the circuit in the standby mode, the circuit drawing a second level of power from the power source, and
wherein the second level is below the first level.

17. The method of Claim 15, wherein the generating step comprises generating the interference compensation signal based on at least one parameter, and
wherein placing at least the portion of the circuit in the standby mode comprises the steps of:
storing the at least one parameter in a memory; and
reducing power consumption of at least the portion of the circuit while supplying the memory with power.

18. The method of Claim 15, wherein the determining step comprises determining whether signal transmission on the first communication channel is present.

## Patentansprüche

1. System (100) zum Handhaben von Kommunikationssignalen, umfassend:
einen ersten Kanal (110, 120), der betrieben werden kann, um erste Kommunikationssignale von einer ersten Signalquelle (135, 145) innerhalb des Systems zu einem ersten Empfänger (135, 140) innerhalb des Systems zu senden;
einen zweiten Kanal, der betrieben werden kann, um zweite Kommunikationssignale zu empfangen und eine Interferenz aus den gesendeten ersten Kommunikationssignalen zu empfangen; und
einen dritten Kanal (115, 125), der induktiv mit dem ersten Kanal gekoppelt ist und betrieben werden kann, um die ersten Kommunikationssignale für die Eingabe in eine Interferenzkompensationsschaltung zu erfassen;
**dadurch gekennzeichnet, dass**
der erste Kanal (110, 120) einen ersten Leiter umfasst, der an einem Substrat angebracht ist, der zweite Kanal einen zweiten Leiter umfasst, der an dem Substrat angebracht ist, der dritte Kanal (115, 125) einen dritten Leiter umfasst, der an dem Substrat angebracht und jeweils von dem ersten Leiter und dem zweiten Leiter getrennt ist, und der dritte Leiter ein leitfähiges Segment umfasst, dass sich parallel und in dichter Nähe zu dem ersten Leiter erstreckt.

2. System (100) nach Anspruch 1, wobei das System die Interferenzkompensationsschaltung (130) umfasst und die Interferenzkompensationsschaltung betrieben werden kann, um in einem aktiven Modus zum Anwenden der Interferenzkompensation und einem Bereitschaftsmodus zu arbeiten.

3. System (100) nach Anspruch 1, wobei das System weiterhin eine Stromquelle umfasst, die mit der Interferenzkompensationsschaltung verbunden ist, und
die Interferenzkompensationsschaltung (130) betrieben werden kann, um jeweils in einem aktiven Modus und einem passiven Modus zu arbeiten und in dem aktiven Modus mehr Strom von der Stromquelle als in dem passiven Modus zu beziehen.

4. System (100) nach Anspruch 1, weiterhin umfassend die Interferenzkompensationsschaltung (130),
wobei die Interferenzkompensationsschaltung in einem ersten Modus betrieben werden kann, um ein Interferenzkompensationssignal auf der Basis der erfassten ersten Kompensationssignale auszugeben, und
die Interferenzkompensationsschaltung in einem zweiten Modus betrieben werden kann, um die Ausgabe des Interferenzkompensationssignals auszusetzen, während wenigstens etwas Strom verbraucht wird.

5. System (100) nach Anspruch 1, bei dem der erste Kanal (110, 120) einen ersten Leiter umfasst, wobei ein zweiter Empfänger (105) in dem zweiten Kanal enthalten ist und betrieben werden kann, um die zweiten Kommunikationssignale zu empfangen, und der dritte Kanal (115, 125) einen zweiten Leiter umfasst.

6. System (100) nach Anspruch 5, weiterhin umfassend eine Folie eines dielektrischen Materials, wobei der erste Leiter und der zweite Leiter in dem dielektrischen Material eingebettet sind und der zweite Leiter mit dem ersten Leiter induktiv gekoppelt und von dem ersten Leiter in wenigstens einem bestimmten Frequenzbereich isoliert ist.

7. System (100) nach Anspruch 5, bei dem der erste Leiter und der zweite Leiter entlang einer gemeinsamen Ebene angeordnet und voneinander durch wenigstens einen bestimmten Abstand getrennt sind.

8. System (100) nach Anspruch 5, bei dem der erste Leiter und der zweite Leiter auf einem flexiblen Film angeordnet sind.

9. System (100) nach Anspruch 5, bei dem der zweite Leiter mit dem ersten Leiter induktiv gekoppelt und den ersten Leiter querend angeordnet ist.

10. System (100) nach Anspruch 5, weiterhin umfassend:
einen Datenbus, der den ersten Leiter (110, 120) umfasst; und
eine Funkantenne, die in dem zweiten Kanal enthalten ist.

11. System (100) nach Anspruch 5, bei dem:
die erste Signalquelle eine Abbildungsvorrichtung (140) umfasst;
der erste Empfänger einen Prozessor (135) umfasst;
die ersten Signale digitale Signale umfassen;
die zweiten Signale drahtlose Signale umfassen;
der zweite Kanal eine Antenne umfasst; und
das System weiterhin eine Schaltung (130) umfasst, die mit dem zweiten Leiter verbunden ist und betrieben werden kann, um die abgetasteten ersten gesendeten Signale zu empfangen und dritte Signale an den zweiten Empfänger auszugeben, um die gekoppelte Interferenz zu löschen.

12. System nach Anspruch 5, weiterhin umfassend ein dielektrisches Material, das zwischen dem ersten Leiter und dem zweiten Leiter angeordnet ist und betrieben werden kann, um den zweiten Leiter von einem Gleichstrom zu isolieren, der sich auf dem ersten Leiter ausbreitet, wobei der zweite Leiter mit dem ersten Leiter induktiv gekoppelt ist, um die ersten gesendeten Signale abzutasten.

13. System nach Anspruch 5, weiterhin umfassend eine Schaltung (130), die mit dem zweiten Leiter verbunden ist und betrieben werden kann, um ein Interferenzkorrektursignal auszugeben, sofern sich die abgetasteten ersten Signale über einem Schwellenwert befinden, und die Ausgabe des Interferenzkorrektursignals auszusetzen, sofern sich die abgetasteten ersten Signale unter dem Schwellenwert befinden.

14. System nach Anspruch 5, weiterhin umfassend eine integrierte Schaltung, die mit dem zweiten Leiter gekoppelt ist und betrieben werden kann, um eine Interferenzkorrektur an dem zweiten Empfänger auf der Basis der abgetasteten ersten gesendeten Signale auszuführen, und weiterhin betrieben werden kann, um in einen Bereitschaftsmodus in Erwiderung darauf überzugehen, dass die erste Signalquelle oder der erste Empfänger oder der zweite Empfänger in einen inaktiven Zustand übergehen.

15. Verfahren zum Verringern einer Interferenz zwischen einem ersten Kommunikationskanal und einem zweiten Kommunikationskanal eines Kommunikationssystems, wobei das Verfahren folgende Schritte umfasst:
Erzeugen eines Interferenzkompensationssignals auf der Basis einer Schätzung einer Interferenz, die induktiv in einen dritten Kommunikationskanal aus einem ersten Kommunikationskanal gekoppelt ist, mit Hilfe einer Schaltung;
Anwenden des Interferenzkompensationssignals auf einen zweiten Kommunikationskanal, um die Interferenz zu reduzieren;
Bestimmen, ob sich der erste Kommunikationskanal in einem aktiven Zustand befindet; und
sofern sich der erste Kommunikationskanal nicht in dem aktiven Zustand befindet, Versetzen wenigstens eines Teils der Schaltung in einen Bereitschaftsmodus,
**dadurch gekennzeichnet, dass**
der erste Kanal einen ersten Leiter umfasst, der an einem Substrat angebracht ist, der zweite Kanal einen zweiten Leiter umfasst, der an einem Substrat angebracht ist, und der dritte Kanal einen dritten Leiter umfasst, der an dem Substrat getrennt von dem ersten Leiter und dem zweiten Leiter angebracht ist und sich parallel sowie in dichter Nähe zu dem ersten Leiter erstreckt.

16. Verfahren nach Anspruch 15, bei dem der Erzeugungsschritt weiterhin umfasst, dass die Schaltung einen ersten Strompegel aus einer Stromquelle zieht,
wobei das Verfahren weiterhin den Schritt umfasst, dass in Erwiderung darauf, wenigstens den Teil der Schaltung in den Bereitschaftsmodus zu versetzen, die Schaltung einen zweiten Strompegel aus der Stromquelle zieht und
der zweite Pegel unter dem ersten Pegel liegt.

17. Verfahren nach Anspruch 15, bei dem der Erzeugungsschritt das Erzeugen des Interferenzkompensationssignals auf der Basis wenigstens eines Parameters umfasst und
das Versetzen wenigstens des Teils der Schaltung in den Bereitschaftsmodus folgende Schritte umfasst:
Speichern des wenigstens einen Parameters in einem Speicher; und
Verringern des Stromverbrauchs wenigstens des Teils der Schaltung, während der Speicher mit Strom versorgt wird.

18. Verfahren nach Anspruch 15, bei dem der Bestimmungsschritt das Bestimmen umfasst, ob eine Signalsendung auf dem ersten Kommunikationskanal vorhanden ist.

## Revendications

1. Système (100) permettant de prendre en charge des signaux de communication, comprenant :
un premier canal (110, 120) fonctionnant pour transmettre des premiers signaux de communication depuis une première source de signaux (135, 145) dans le système vers un premier récepteur (135, 140) à l'intérieur du système,
un deuxième canal fonctionnant pour recevoir des seconds signaux de communication et pour recevoir des interférences provenant des premiers signaux de communication transmis, et
un troisième canal (115, 125) couplé par induction au premier canal, fonctionnant pour détecter les premiers signaux de communication en vue d'une application en entrée sur un premier circuit de compensation d'interférences,
**caractérisé en ce que**
le premier canal (110, 120) comprend un premier conducteur fixé à un substrat, le deuxième canal comprend un deuxième conducteur fixé au substrat, le troisième canal (115, 125) comprend un troisième conducteur fixé au substrat et séparé de chacun du premier conducteur et du deuxième conducteur, et le troisième conducteur comprend un segment conducteur s'étendant parallèlement et en proximité rapprochée du premier conducteur.

2. Système (100) selon la revendication 1, dans lequel le système comprend le circuit de compensation des interférences (130), et dans lequel le circuit de compensation des interférences fonctionne pour opérer dans un mode actif afin d'appliquer une compensation des interférences, ainsi que dans un mode d'attente.

3. Système (100) selon la revendication 1, dans lequel le système comprend en outre une source d'énergie reliée au circuit de compensation des interférences, et
dans lequel le circuit de compensation des interférences (130) fonctionne pour opérer dans chacun d'un mode actif et d'un mode passif ainsi que pour obtenir plus d'énergie de la source d'énergie dans le mode actif que dans le mode passif.

4. Système (100) selon la revendication 1, comprenant en outre le circuit de compensation des interférences (130),
dans lequel le circuit de compensation des interférences fonctionne dans un premier mode pour fournir en sortie un signal de compensation des interférences fondé sur les premiers signaux de communication détectés, et
dans lequel le circuit de compensation des interférences fonctionne dans un second mode pour interrompre la fourniture en sortie du signal de compensation des interférences tout en consommant au moins une certaine énergie.

5. Système (100) selon la revendication 1, dans lequel le premier canal (110, 120) comprend un premier conducteur, dans lequel un second récepteur (105) est compris dans le deuxième canal et fonctionne pour recevoir des deuxièmes signaux de communication, tout comme dans lequel le troisième canal (115, 125) comprend un deuxième conducteur.

6. Système (100) selon la revendication 5, comprenant en outre une feuille de matériau diélectrique, le premier conducteur et le deuxième conducteur étant inclus dans le matériau diélectrique, et dans lequel le deuxième conducteur est couplé par induction au premier conducteur et est isolé du premier conducteur dans au moins une certaine plage de fréquences.

7. Système (100) selon la revendication 5, dans lequel le premier conducteur et le deuxième conducteur sont disposés le long d'un plan commun et sont séparés l'un de l'autre d'au moins une certaine distance.

8. Système (100) selon la revendication 5, dans lequel le premier conducteur et le deuxième conducteur sont disposés sur un film souple.

9. Système (100) selon la revendication 5, dans lequel le deuxième conducteur est couplé par induction au premier conducteur et est placé d'un côté à l'autre du premier conducteur.

10. Système (100) selon la revendication 5, comprenant en outre :
un bus de données comprenant le premier conducteur (110, 120), et
une antenne radio comprise dans le deuxième canal.

11. Système (100) selon la revendication 5, dans lequel :
la première source de signaux comprend un dispositif de formation d'images (140),
le premier récepteur comprend un processeur (135),
les premiers signaux comprennent des signaux numériques,
les deuxièmes signaux comprennent des signaux sans fil,
le deuxième canal comprend une antenne, et
le système comprend en outre un circuit (130) relié au deuxième conducteur fonctionnant pour recevoir les premiers signaux transmis échantillonnés et pour fournir en sortie des troisièmes signaux vers le deuxième récepteur afin d'annuler les interférences couplées.

12. Système (100) selon la revendication 5, comprenant en outre un matériau diélectrique disposé entre le premier conducteur et le deuxième conducteur, fonctionnant pour isoler le deuxième conducteur du courant continu se propageant sur le premier conducteur, dans lequel le deuxième conducteur est couplé par induction au premier conducteur afin d'échantillonner les premiers signaux transmis.

13. Système (100) selon la revendication 5, comprenant en outre un circuit (130) relié au deuxième conducteur, fonctionnant pour fournir en sortie un signal de correction des interférences si les premiers signaux échantillonnés se trouvent au-dessus d'un seuil ainsi que pour interrompre la fourniture en sortie du signal de correction des interférences si les premiers signaux échantillonnés se trouvent en dessous du seuil.

14. Système (100) selon la revendication 5, comprenant en outre un circuit intégré, relié au deuxième conducteur, fonctionnant pour appliquer une correction des interférences au second récepteur sur la base des premiers signaux transmis échantillonnés, et fonctionnant en outre pour passer à un mode d'attente en réponse à l'un de la première source de signaux, du premier récepteur et du deuxième récepteur passant à un état inactif.

15. Procédé de réduction des interférences entre un premier canal de communication et un deuxième canal de communication appartenant à un système de communication, le procédé comprenant les étapes suivantes :
la génération d'un signal de compensation des interférences fondé sur une estimation des interférences couplées par induction à un troisième canal de communication à partir d'un premier canal de communication, en utilisant un circuit,
l'application du signal de compensation des interférences à un deuxième canal de communication afin de réduire les interférences,
la détermination de ce que le premier canal de communication est dans un état actif, et
si le premier canal de communication n'est pas à l'état actif, le placement d'au moins une partie du circuit dans un mode d'attente,
**caractérisé en ce que**
le premier canal comprend un premier conducteur fixé à un substrat, le deuxième canal comprend un deuxième conducteur fixé à un substrat et le troisième canal comprend un troisième conducteur fixé au substrat, séparé de chacun du premier conducteur et du deuxième conducteur et s'étendant parallèlement et à proximité rapprochée du premier conducteur.

16. Procédé selon la revendication 15, dans lequel l'étape de génération comprend en outre le circuit absorbant un premier niveau d'énergie provenant d'une source d'énergie,
dans lequel le procédé comprend en outre l'étape, en réponse au placement d'au moins une partie du circuit dans le mode d'attente, de l'absorption par le circuit d'un second niveau d'énergie de la source d'énergie, et
dans lequel le second niveau se trouve en dessous du premier niveau.

17. Procédé selon la revendication 15, dans lequel l'étape de génération comprend la génération d'un signal de compensation des interférences sur la base d'au moins un paramètre, et
dans lequel le placement d'au moins la partie du circuit dans le mode d'attente comprend les étapes suivantes :
le stockage du ou des paramètres dans une mémoire, et
la réduction de consommation d'énergie d'au moins la partie du circuit tout en fournissant de l'énergie à la mémoire.

18. Procédé selon la revendication 15, dans lequel l'étape de détermination comprend la détermination de ce que la transmission de signaux sur le premier canal de communication est présente.
